# EUROPEAN PATENT SPECIFICATION

(11) **EP 3 635 767 B1**
(45) Date of publication and mention of the grant of the patent: **26.10.2022**
(21) Application number: 18812642.9
(22) Date of filing: 05.06.2018
(51) Int. Cl.: H01J 37/34, H01J 37/32, C23C 14/35, C23C 14/34

(54) **PROCESS KIT FOR MULTI-CATHODE PROCESSING CHAMBER**
PROZESSSATZ FÜR EINE MEHRKATHODEN-VERARBEITUNGSKAMMER
KIT DE TRAITEMENT POUR CHAMBRE DE TRAITEMENT MULTI-CATHODE

(30) Priority: 05.06.2017 US 201715614595
(43) Date of publication of application: 15.04.2020
(73) Proprietor: Applied Materials, Inc., Santa Clara, CA 95054 (US)
(72) Inventor: WU, Hanbing, Millbrae, California 94030 (US); SUBRAMANI, Anantha K., San Jose, California 95135 (US); GOEL, Ashish, Bangalore 560 075 Karnataka (IN); JADHAV, Deepak, Hubli 580 030 (IN); WANG, Rongjun, Dublin, California 94568 (US); CHING, Chi Hong, Santa Clara, California 95051 (US)
(74) Representative: Zimmermann & Partner Patentanwälte mbB
(86) International application number: PCT/US2018/036044
(87) International publication number: WO 2018/226683

(56) References cited:
- CN-A- 101 989 544
- JP-A- 2013 168 690
- KR-A- 20050 038 898
- US-A1- 2005 061 447
- US-A1- 2015 279 635
- US-A1- 2015 279 635
- US-A1- 2015 303 042
- US-A1- 2017 076 924

## Description

### FIELD

Embodiments of the present disclosure generally relate to process kits for a multi-cathode processing chamber.

### BACKGROUND

Physical vapor deposition (PVD) in semiconductor fabrication is typically performed with a target made of a desired film material. In the case of alloys, the targets are typically composed of the alloy to be sputtered. In the case of new nonvolatile memories, alloys of different compositions are used. As such, multiple targets in a multi-cathode (e.g., multi-target) PVD chamber have been utilized to sequentially deposit the different materials. US 2015/0279635 A1 relates to a deposition system with multi-cathode. US 2015/0303042 A1 relates to a sputtering apparatus. However, because of the cross-contamination of the multiple targets, the targets are cleaned periodically to maintain film consistency. For example, one or more of the multiple targets may be covered by shutters during the cleaning process, which may lead to particle generation. US 2017/076924 A1 relates to a deposition shield arrangement at the substrate support for a single target sputtering system to prevent contamination.

Therefore, the inventors have provided embodiments of process kits for a multi-cathode processing chamber.

### SUMMARY

According to an aspect, a process kit for use in a multi-cathode processing chamber according to independent claim 1 is provided. A process kit includes components, such as one or more of a conical shield, a rotatable shield, a shroud, an inner deposition ring, an outer deposition ring, and a cover ring. The process kit components can be used together in a process kit for a multi-cathode processing chamber.

In some embodiments, a process kit component for use in a multi-cathode processing chamber includes: a conical shield having a substantially vertical top portion, a middle portion angled radially inward and downward from the top portion, and a bottom portion that extends substantially vertically downward from the end of the middle portion opposite the top portion; and a flange extending radially outwardly from the top portion.

In some embodiments, a process kit component for use in a multi-cathode processing chamber includes: a rotatable shield having a base, a conical portion extending downward and radially outward from the base, and a collar portion extending radially outward from the bottom of the conical portion; and a hole disposed through the conical portion.

In some embodiments, a process kit component for use in a multi-cathode processing chamber includes: a shroud comprising a tubular body having a planar end and an opposing curved end, wherein the tubular body has an egg-shaped cross-section along the predominant portion thereof, from the curved end to proximate the planar end, and wherein the cross-section of the planar end is smoothly reduced from the egg-shaped cross-section to a circular cross-section; and a first flange proximate the planar end.

In some embodiments, a process kit component for use in a multi-cathode processing chamber includes: an inner deposition ring comprising a leg portion, a flat portion extending radially inward from the leg portion, a recessed portion extending radially inward from the flat portion, and a lip extending upward from an innermost section of the recessed portion.

In some embodiments, a process kit component for use in a multi-cathode processing chamber includes: an outer deposition ring comprising a collar portion, an upper flat portion disposed above and radially inward from the collar portion, a recessed portion extending inward from the upper flat portion, and a lip extending upward from an innermost section of the recessed portion.

In some embodiments, a process kit component for use in a multi-cathode processing chamber includes: a cover ring comprising a base section, a ring portion that curves up from the base section to form a bowl, and an annular foot that extends downward from the base section.

In some embodiments, a process kit for use in a multi-cathode processing chamber includes a rotatable shield having a base, a conical portion extend downward and radially outward from the base, and a collar portion extending radially outward from a bottom of the conical portion, wherein an egg-shaped hole is formed through the conical portion; an inner deposition ring having a leg portion, a flat portion extending radially inward from the leg portion, a first recessed portion extending radially inward from the flat portion, and a first lip extending upward from an innermost section of the first recessed portion; and an outer deposition ring having a collar portion, an upper flat portion disposed above and extending radially inward from the collar portion, a second recessed portion extending inward from the upper flat portion, and a second lip extending upward from an innermost section of the second recessed portion.

In some embodiments, a multi-cathode processing chamber includes a substrate support to support a substrate; a plurality of cathodes coupled to a carrier and having a corresponding plurality of targets to be sputtered onto the substrate; and a process kit disposed within the process chamber. The process kit includes a rotatable shield rotatably disposed between the substrate support and the plurality of targets, wherein the shield includes a base, a conical portion extend downward and radially outward from the base, and a collar portion extending radially outward from a bottom of the conical portion, wherein the shield includes an egg-shaped hole formed through the conical portion to expose one of the plurality of targets while covering the remainder of the plurality of targets; an inner deposition ring configured to be disposed atop the substrate support and beneath an outer edge of the substrate, wherein the inner deposition ring includes a leg portion, a flat portion extending radially inward from the leg portion, a first recessed portion extending radially inward from the flat portion, and a first lip extending upward from an innermost section of the first recessed portion; and an outer deposition ring disposed radially outward of the inner deposition ring and having a collar portion, an upper flat portion disposed above and extending radially inward from the collar portion, a second recessed portion extending inward from the upper flat portion, and a second lip extending upward from an innermost section of the second recessed portion, wherein the leg portion of the inner deposition ring extends into the second recessed portion of the outer deposition ring to form a tortuous path between the inner and outer deposition rings.

In some embodiments, a process kit for use in a multi-cathode processing chamber includes a rotatable shield having a base, a conical portion extend downward and radially outward from the base, and a collar portion extending radially outward from a bottom of the conical portion, wherein an egg-shaped hole is formed through the conical portion; an inner deposition ring having a leg portion, a flat portion extending radially inward from the leg portion, a first recessed portion extending radially inward from the flat portion, and a first lip extending upward from an innermost section of the first recessed portion; an outer deposition ring having a collar portion, an upper flat portion disposed above and extending radially inward from the collar portion, a second recessed portion extending inward from the upper flat portion, and a second lip extending upward from an innermost section of the second recessed portion; a plurality of shrouds configured to be disposed about a corresponding plurality of targets between the plurality of targets and the rotatable shield; a conical shield, wherein a top section of the conical shield is configured to surround a lower portion of the rotatable shield, and wherein a bottom section of the conical shield is configured to surround a substrate support; and a cover ring configured to rest on the bottom section of the conical shield.

Other and further embodiments of the present disclosure are described below.

### BRIEF DESCRIPTION OF THE DRAWINGS

Embodiments of the present disclosure, briefly summarized above and discussed in greater detail below, can be understood by reference to the illustrative embodiments of the disclosure depicted in the appended drawings. However, the appended drawings illustrate only typical embodiments of the disclosure and are therefore not to be considered limiting of scope, for the disclosure may admit to other equally effective embodiments.
Figure 1 depicts a cross-sectional view of a multi-cathode processing chamber in accordance with some embodiments of the present disclosure.
Figure 2 depicts a zoomed cross-sectional view of a deposition ring of the multi-cathode processing chamber of Figure 1.
Figure 3 depicts a perspective bottom view of a deposition ring in accordance with some embodiments of the present disclosure.
Figure 4 depicts a perspective top view of a rotatable shield in accordance with some embodiments of the present disclosure.
Figure 5 depicts a cross-section view of the rotatable shield of Figure 4 taken along line 5-5'.
Figure 6 depicts a cross-sectional view of a conical shield of the multi-cathode processing chamber of Figure 1.
Figure 7 depicts a cross-sectional view of a shroud of the multi-cathode processing chamber of Figure 1 in accordance with some embodiments of the present disclosure.
Figure 8 depicts a cross-sectional view of another shroud of the multi-cathode processing chamber of Figure 1 in accordance with some embodiments of the present disclosure.

To facilitate understanding, identical reference numerals have been used, where possible, to designate identical elements that are common to the figures. The figures are not drawn to scale and may be simplified for clarity. Elements and features of one embodiment may be beneficially incorporated in other embodiments without further recitation.

### DETAILED DESCRIPTION

Embodiments of a process kit for use in a multi-cathode processing chamber are provided herein. The disclosed process kit may advantageously minimize or eliminate cross-contamination between targets. In addition, the disclosed process kit minimizes in the deposition of material on chamber components outside of the processing volume.

In some embodiments, a multi cathode-PVD chamber includes a plurality of cathodes, or targets, (for example, 5 cathodes) attached to a top adapter. Each cathode can have a DC/Pulse DC or RF target and an associated magnetron. Each cathode also has a shroud which is long tube which does not block a line of sight from the target to wafer. A common rotatable shield is provided in the center of the chamber that is shared by all the cathodes. Depending on the number of targets that need to be sputtered at the same time, the rotatable shield can have one or more holes, such as 1, 2, or 3 holes. The shroud surrounding each target advantageously captures a majority of the target flux that is not directed towards the wafer and hence likely to land on the wafer, thus significantly minimizing target cross-contamination. In some embodiments, the shroud material and surface treatment can be tailored to a specific target material being sputtered, thus improving defect performance.

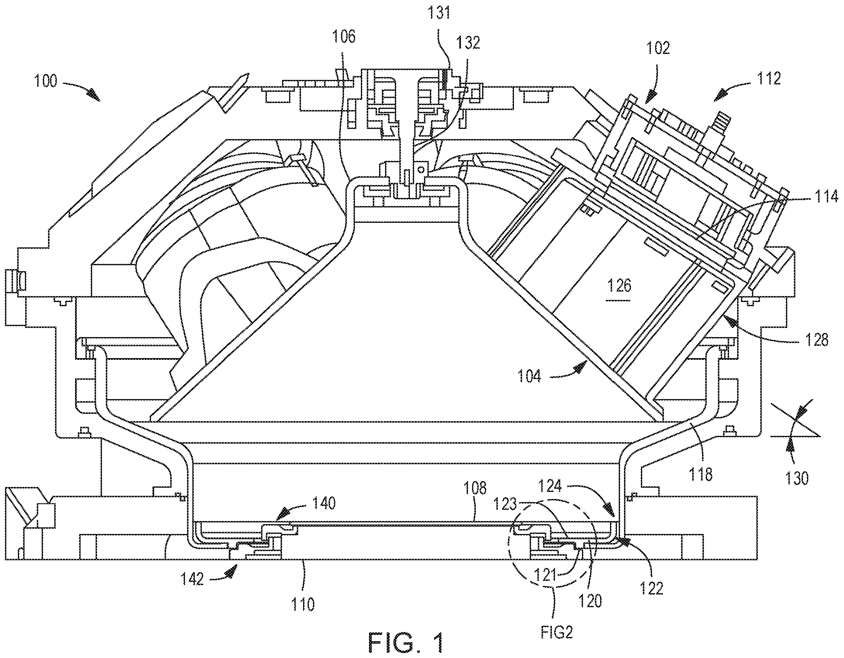

Figure 1 depicts a schematic cross-sectional view of a multi-cathode processing chamber (process chamber 100) in accordance with some embodiments of the present disclosure. The process chamber 100 includes a plurality of cathodes 102 (e.g., five cathodes) coupled to an upper portion of the process chamber 100 having a process kit 150 and a substrate support 110 disposed within the process chamber 100 below the plurality of cathodes 102. In some embodiments, the substrate support 110 may be a rotating pedestal. In some embodiments, the substrate support 110 may be vertically movable.

The plurality of cathodes 102 can be used for sputtering different materials on a substrate 108. In some embodiments, the substrate 108 is a structure having a semiconductor material used for fabrication of integrated circuits. For example, the substrate 108 can represent a semiconductor structure including a wafer.

In some embodiments, the process kit 150 includes a rotatable shield 106 to selectively cover one or more of the plurality of cathodes 102. The cathodes 102 are each exposed through an opening or hole 104 of the rotatable shield 106, which is disposed over the substrate 108 on the substrate support 110. In some embodiments, the rotatable shield 106 includes a single hole 104. Materials from the cathodes 102 can be deposited onto the substrate 108 through the hole 104.

A power supply 112 may be coupled to each of the plurality of cathodes 102. The power supply 112 may include direct current (DC), pulsed DC, or radio frequency (RF) power. The rotatable shield 106 may expose two or more of the plurality of cathodes 102 and shield remaining cathodes 102 from cross-contamination during sputtering. The cross-contamination results from physical movement or transfer of a deposition material from one of the cathodes 102 to another one of the cathodes 102. Each cathode 102 is positioned over a corresponding target 114. To sputter the selected target, the rotatable shield 106 is rotated to expose the selected target to be sputtered. The targets 114 may be formed of any material desired to be sputtered onto the substrate 108. A motor 131 is coupled to the rotatable shield 106 via a shaft 132 to facilitate the rotation of the rotatable shield 106.

In some embodiments, the process kit 150 further includes a shroud 126, which is a long tube that does not block a line of sight from the target 114 to a substrate disposed on the substrate support 110, corresponding to each cathode 102. Each shroud 126 includes a shroud rotation 128 to provide the cathodes 102 at an angle 130 of about 20 to 90 degrees. Different values of the angle 130 provide different uniformity profiles on a surface of the substrate. The angle 130 is measured between a plane of one of the targets 114 and a plane of the substrate support 110. In some embodiments, the angle 130 is about 30 degrees. In some embodiments, the angle 130 is alternatively about 40 degrees. Each shroud is configured to capture a majority of the target flux that is not directed towards and hence likely to land on substrate. As such, the shrouds significantly minimize target cross contamination. Additionally, the shroud material and surface treatment of the shroud may be tailored to specific target materials, thus improving defect performance.

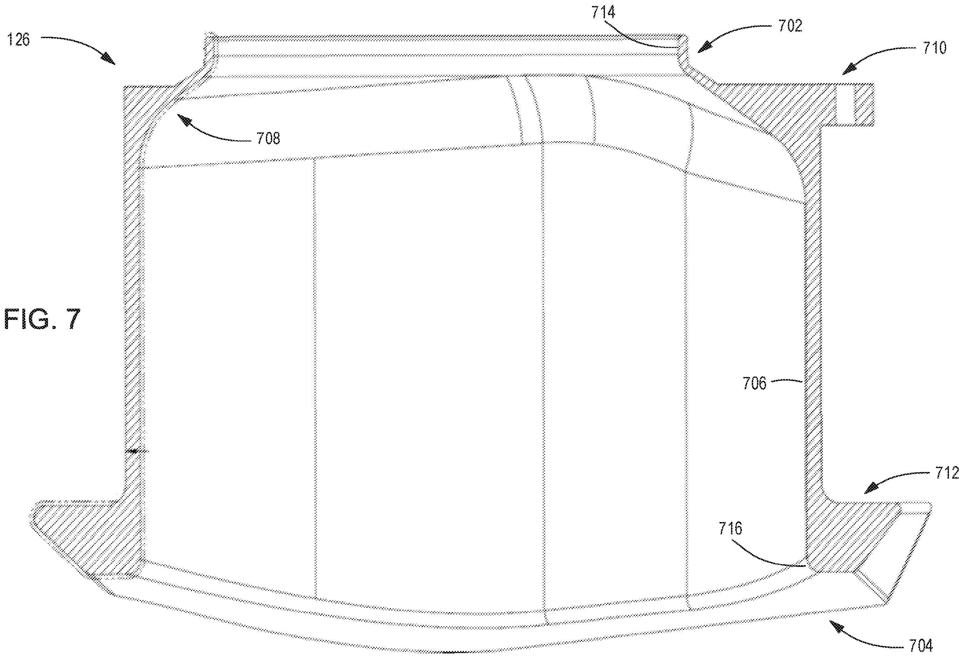

As shown in greater detail in Figure 7, each shroud 126 includes a tubular body 706 having a planar end 702 configured to be coupled to respective cathodes 102 and an opposing curved end 704 configured to interface with the rotatable shield 106. The opening 716 of the tubular body 706 of the shroud 126 at the curved end 704 is generally the same size and shape as the hole 104 in the rotatable shield 106. The tubular body 706 can have an egg-shaped cross-section along the predominant portion thereof, from the curved end 704 to proximate the planar end 702. The cross-section of the planar end 702 is smoothly reduced from the egg-shaped cross-section to a circular cross-section as indicated at 708. The tubular body 706 can include a first flange 710 proximate the planar end 702. In some embodiments, the circular cross-section is about 15.7 to about 16.0 cm (about 6.2 to about 6.3 inches). The first flange 710 can include a plurality of openings, such as three openings, to facilitate coupling the shroud 126 to the respective cathode 102 to which the particular shroud 126 is to be attached. The tubular body 706 can further include a second flange 712 proximate the curved end 704. Interior surfaces of the shroud 126 can be texturized, for example with an aluminum arc spray, such as a twin wire arc spray to enhance particle retention. The second flange 712 can also be texturized as described above.

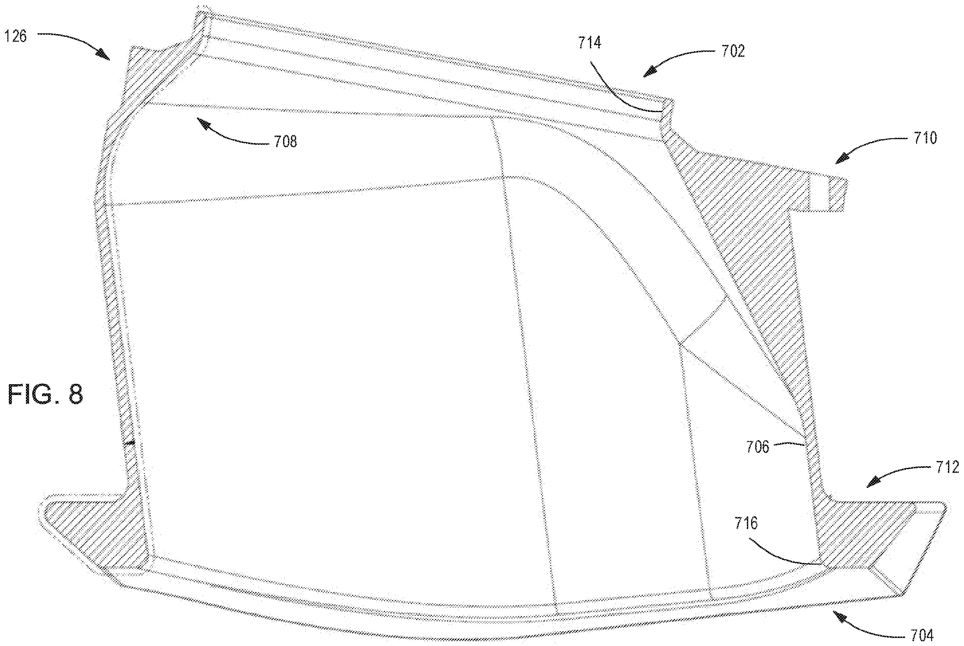

In some embodiments, and as shown in Figure 7, a central axis of the circular opening in the planar end 702 of the tubular body 706 is parallel to a central axis of the egg-shaped opening in the curved end 704. In some embodiments, and as shown in Figure 8, a central axis of the circular opening in the planar end 702 of the tubular body 706 is disposed at an angle to a central axis of the egg-shaped opening in the curved end 704. In some embodiments, the angle is about 10 degrees.

Returning to Figure 1, in some embodiments, the process kit 150 further includes a conical shield 118, a cover ring 120, an inner deposition ring 140, and an outer deposition ring 142. As depicted in Figure 1, a top section of the conical shield 118 is configured to surround a lower portion of the rotatable shield 106 and a bottom section of the conical shield 118 is configured to surround the substrate support 110. Before the substrate 108 moves into or out of the chamber, the substrate 108 can move below a conical shield 118 disposed on a lower portion of the process chamber. A cover ring 120 is disposed on top of the conical shield 118 and surrounds the substrate 108. When the substrate support 110 moves down, the substrate 108 can be lifted up with a robotic arm (not shown) before the substrate 108 moves out of the chamber.

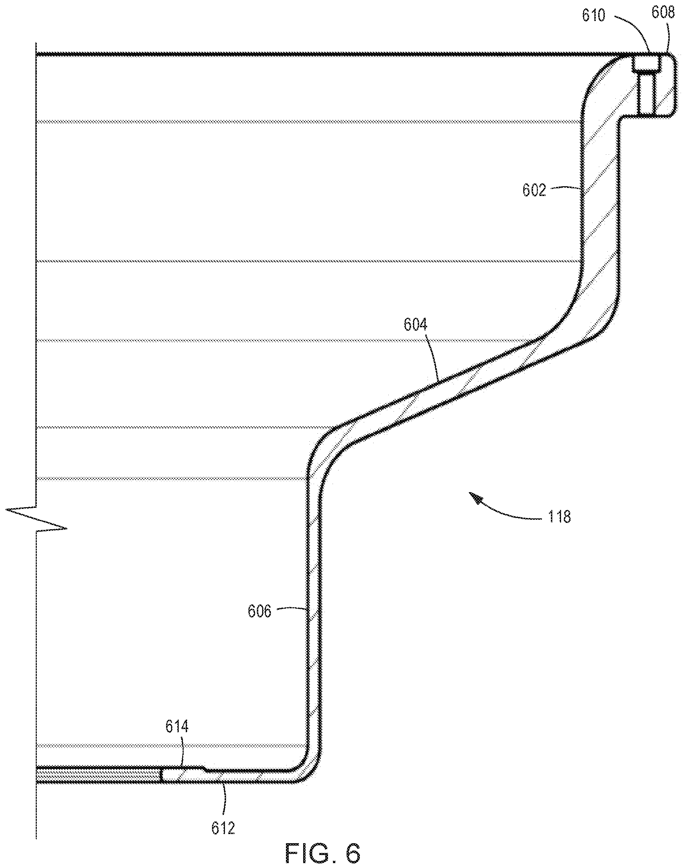

Figure 6 depicts a cross-sectional view of the conical shield 118 in greater detail. As shown in Figure 6, the conical shield generally includes a top portion 602, a middle portion 604, and a bottom portion 606. The top portion 602 is substantially vertical and includes a radially outwardly projecting flange 608. The flange 608 can extend horizontally outward by an amount sufficient to provide a surface to rest upon a chamber component that supports the conical shield 118, such as a wall of the process chamber. In some embodiments, the flange 608 extends radially outward about 2.057 cm (about 0.810 inches) from the outer wall of the top portion 602. A plurality of openings 610 can be provided through the flange 608 to facilitate coupling the conical shield 118 to, for example, a wall of the process chamber. The plurality of openings 610 can be equidistantly spaced along the flange 608. In some embodiments, twelve openings 610 are provided and spaced apart by 30 degrees between adjacent openings 610.

The middle portion 604 is substantially linear and is angled radially inward and downward from the top portion 602. The middle portion 604 can be provided at an angle of about 110 degrees with respect to the top portion 602, as measured between the radially inward facing surfaces of the top portion 602 and the middle portion 604.

The bottom portion 606 is substantially linear and extends vertically downward from the end of the middle portion 604 opposite the top portion 602. The bottom portion includes a radially inwardly projecting flange 612. In some embodiments, the flange 612 has a width of about 5.74 cm (about 2.26 inches) and the flange 612 has an inner diameter of about 38.40 cm (about 15.12 inches). In some embodiments, the flange 612 has a thickness of about 0.43 cm (about 0.17 inches). In some embodiments, the flange 612 includes an inner annular lip 614 that projects upward from the flange 612 along the inner diameter of the flange 612. In some embodiments, the lip 614 extends about 0.10 cm (about 0.04 inches) above the upper surface of the flange 612. In some embodiments, the lip 614 has a width of about 1.5 cm (about 0.6 inches). The inner annular lip 614 has a substantially planar upper surface to provide a reduced contact support surface for the cover ring 120.

The top portion 602 has a diameter sufficient to surround components in the upper region of the process chamber, such as, for example, the rotatable shield 106 and the shroud 126. The middle portion 604 has a varying diameter that decreases from adjacent to the top portion 602 to adjacent to the bottom portion 606. The bottom portion 606 has a diameter smaller than the top portion 602 and sufficient to surround components in the lower region of the process chamber, such as, for example, the substrate support 110, the inner and outer deposition rings 140, 142, and the cover ring 120. For example, in some embodiments, the top portion 602 has an inner diameter of about 68.99 cm (about 27.16 inches), the bottom portion 606 has an inner diameter of about 49.07 cm (about 19.32 inches), and the inner diameter of the middle portion 604 varies linearly between the top portion 602 and the bottom portion 606.

The conical shield 118 can be texturized, for example with an aluminum arc spray, such as a twin wire arc spray to enhance particle retention. In some embodiments, the top portion 602 can be thicker than the middle portion 604 and the bottom portion 606. In some embodiments, the middle portion 604 can be thicker than the bottom portion 606. In some embodiments, the top portion 602 is thicker than the middle portion 604 and the middle portion 604 is thicker than the bottom portion 606. For example, in some embodiments, the top portion 602 has a thickness of about 1.32 cm (about 0.52 inches), the middle portion 604 has a thickness of about 0.64 cm (about 0.25 inches), and the bottom portion 606 has a thickness of about 0.43 cm (about 0.17 inches).

The conical shield 118 can have an overall height of between about 21.6 and about 22.23 cm (about 8.5 and about 8.75 inches), for example about 21.95 cm (about 8.64 inches). In some embodiments, the top portion 602 has a height of about 8.20 cm (about 3.23 inches) (measured from the top of the flange 608 to the outer theoretical sharp corner intersection of the top portion 602 and the middle portion 604). In some embodiments, the bottom portion 606 has a height of between about 11.4 and 11.9 cm (about 4.5 and 4.7 inches), suchas about 11.7 cm (about 4.6 inches) (measured from the bottom of the flange 612 to the outer theoretical sharp corner intersection of the bottom portion 606 and the middle portion 604).

Returning to Figure 1, the cover ring 120 can include a base section 123 and a ring portion 122 that curves up from the base section 123 and has a predefined thickness to form a dish or bowl in which the substrate can be disposed. The ring portion 122 surrounds and is disposed above or at the same height as an upper surface of the substrate 108. The cover ring 120 can further include an annular foot 121 that extends downward from the base section 123.

The cover ring 120 can also include a predefined gap 124 and a predefined length with respect to the conical shield 118. Thus, when materials are deposited on the substrate 108, the materials are prevented or substantially prevented from depositing below the substrate support 110 or outside of the conical shield 118. Controlling the deposition of materials as described advantageously prevents or reduces the spread of contaminants to the substrate 108 or within the process chamber. In some embodiments, upper surfaces of the cover ring 120 can be texturized, for example with an aluminum arc spray, such as a twin wire arc spray to enhance particle retention. In some embodiments, all surfaces of the cover ring 120 can be texturized except for the annular foot 121 and the lower surface of the base section 123 radially outward of the annular foot 121, thus reducing the risk of the cover ring 120 sticking to the conical shield 118.

The cover ring 120 has an outer diameter smaller than the inner diameter of the bottom portion 606 of the conical shield 118 such that the cover ring 120 can be disposed within the central opening of the conical shield 118 and rest upon the flange 612, such as upon the lip 614. In some embodiments, the cover ring 120 has an outer diameter of about 48.0 to about 48.3 cm (about 18.9 to about 19 inches). In some embodiments, the inner diameter of the ring portion 122 is about 46.99 to about 47.63 cm (about 18.50 to about 18.75 inches). In some embodiments, the inner diameter of the base section 123 is between about 33.0 and 33.3 cm (about 13.0 and 13.1 inches). In some embodiments, the cover ring 120 has an overall height of between about 2.3 and 2.5 cm (about 0.9 and 1.0 inches).

In some embodiments, the base section 123 has a thickness of about 0.53 cm (about 0.21 inches). In some embodiments the base section 123 has a planar upper surface and a first lower surface radially outward of the annular foot 121 that defines a first thickness, and a second lower surface radially inward of the annular foot 121 that defines a second thickness, wherein the first thickness is greater than the second thickness. For example, in some embodiments the first thickness is about 0.53 cm (about 0.21 inches) and the second thickness is about 0.46 cm (about 0.18 inches). In some embodiments, the annular foot 121 can protrude from the base section 123, or from the first lower surface of the base section 123, by about 0.43 cm (about 0.17 inches). In some embodiments, the annular foot 121 has an outer diameter of about 37.90 cm (about 14.92 inches) and an inner diameter of about 35.99 cm (about 14.17 inches).

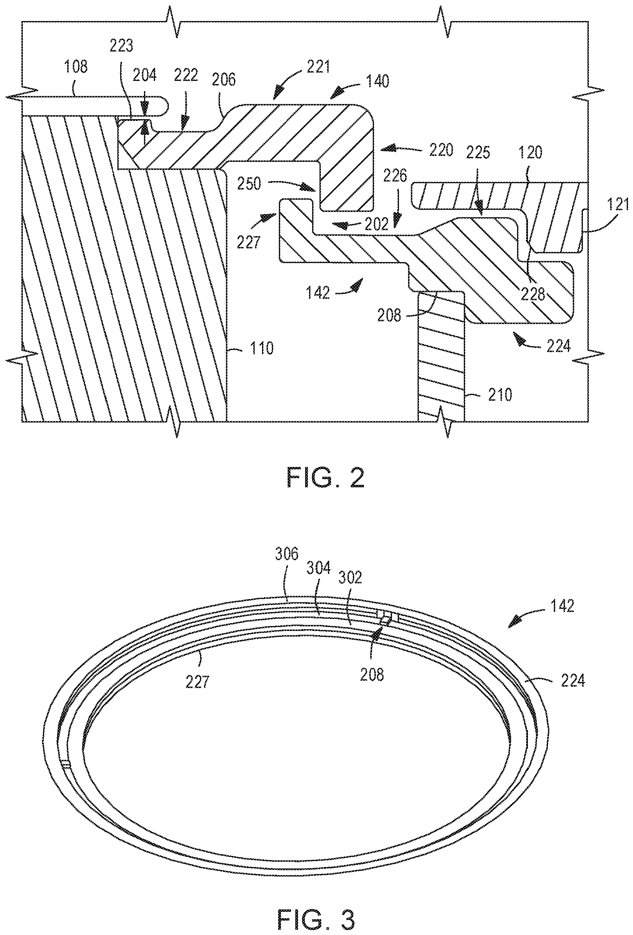

In some embodiments, a lower radially inner portion of the annular foot 121 may be disposed at a shallow, non-perpendicular angle directed in a radially outward direction (for example, as indicated by 228 in Figure 2). In some embodiments, the non-perpendicular angle is about 30 degrees from perpendicular to the base section 123. The angled surface advantageously assists in locating and installing the cover ring 120 atop the outer deposition ring 142.

The inner and outer deposition rings 140, 142 further prevent deposition of the material below the substrate support 110. The inventors have discovered that a twopiece deposition ring advantageously reduces wear caused by a stationary deposition ring that can contact the rotating substrate 108 and/or substrate support 110 causing damage and generating particles that can contaminate the chamber. As such, the inventors have provided the inner deposition ring 140, which sits on and rotates with the substrate support 110, and an outer deposition ring 142, which sits on a stationary chamber component.

Figure 2 depicts a zoomed-in, cross-sectional view of a portion of the process kits depicted in Figure 1. In some embodiments, the inner deposition ring 140 includes a leg portion 220, a flat portion 221 extending radially inward from the leg portion 220, a recessed portion 222 (e.g., a first recessed portion) extending radially inward from the flat portion 221, and a lip 223 (e.g., a first lip) extending upward from an innermost section of the recessed portion 222. In some embodiments, the recessed portion 222 may be formed by an angled wall 206 that extends downward and inward to a flat bottom portion of the recessed portion 222 that terminates at the lip 223. In some embodiments, the inner deposition ring 140 may also include a ledge at the outer periphery of the recessed portion 222 to prevent the substrate 108 from falling off the substrate support 110 in case the substrate 108 moves during rotation of the substrate support 110.

In some embodiments, the bottom surface of the inner deposition ring 140 is defined by the bottom surface of the leg portion 220, the inner wall of the leg portion 220, a first flat surface generally opposite the flat portion 221, an inwardly and downwardly angled wall leading to a second flat surface generally opposite the recessed portion 222, and an upwardly angled wall that terminates at an inner wall of the inner deposition ring 140. In some embodiments, a lowermost innermost edge of the inner deposition ring 140 (e.g., at the intersection of the second flat surface and the inner wall) is chamfered, for example, at about 45 degrees.

In some embodiments, the inner deposition ring 140 has an outer diameter of about 32.3 to about 32.8 cm (about 12.7 to about 12.9 inches). In some embodiments, the inner deposition ring 140 has an inner diameter of about 29.0 to about 29.5 cm (about 11.4 to about 11.6 inches). In some embodiments, the inner deposition ring 140 has a width of about 1.40 to about 1.65 cm (about 0.55 to about 0.65 inches). In some embodiments, the inner deposition ring 140 has an overall height of about 0.51 to about 0.76 cm (about 0.20 to about 0.3 inches). In some embodiments, the leg portion 220 of the inner deposition ring 140 has a width of about 1.91 to about 3.8 cm (about 0.75 to about 1.5 inches). In some embodiments, an inner wall of the leg portion 220 has a diameter of about 31.8 to about 32.0 cm (about 12.5 to about 12.6 inches). In some embodiments, the lip 223 has a width of about 0.13 to about 0.20 cm (about 0.05 to about 0.08 inches).

Upper surfaces of the inner deposition ring 140 can be texturized, for example with an aluminum arc spray, such as a twin wire arc spray to enhance particle retention. In some embodiments, all surfaces of the inner deposition ring 140 can be texturized as described above with the exception of the bottom surfaces from the inner wall of the leg portion 220 to the inner peripheral edge of a planar bottom surface opposite the recessed portion 222.

In some embodiments, the outer deposition ring 142 includes a collar portion 224, an upper flat portion 225 disposed above and radially inward from the collar portion 224, a recessed portion 226 (e.g., a second recessed portion) extending inward from the upper flat portion 225, and a lip 227 (e.g., a second lip) extending upward from an innermost section of the recessed portion 226. The collar portion 224 defines a ledge that sits below and extends radially outwardly from the upper flat portion 225.

In some embodiments, the upper surface of the outer deposition ring 142 is defined between the ledge of the collar portion 224, the upper flat portion 225, the recessed portion 226, and the lip 227. In some embodiments, and as depicted in Figures 2 and 3, the lower surface of the outer deposition ring 142 is stepped and includes an innermost flat portion 302 (generally opposite the lip 227 and the recessed portion 226), an intermediate flat portion 304 (generally opposite the sloped surface between the recessed portion 226 and the upper flat portion 225), and an outermost flat portion 306 (generally opposite the upper flat portion 225 and extending radially outward along the collar portion 224). Vertical walls connect the innermost, intermediate, and outermost flat portions 302, 304, 306 of the lower surface of the outer deposition ring 142.

In some embodiments, the outer deposition ring 142 has an outer diameter of about 36.8 to about 37.3 cm (about 14.5 to about 14.7 inches). In some embodiments, the outer deposition ring 142 has an inner diameter of about 30.7 to about 31.2 cm (about 12.1 to about 12.3 inches). In some embodiments, the outer deposition ring 142 has a width of about 2.8 to about 3.3 cm (about 1.1 to about 1.3 inches). In some embodiments, the outer deposition ring 142 has an overall height of about 1.0 to about 1.5 cm (about 0.4 to about 0.6 inches). In some embodiments, the lip 227 of the outer deposition ring 142 has a width of about 1.91 to about 3.8 cm (about 0.75 to about 1.5 inches). In some embodiments, the lip 227 of the outer deposition ring 142 has a height of about 0.3 to about 0.5 cm (about 0.1 to about 0.2 inches) above the recessed portion 226. In some embodiments, the recessed portion 226 has a bottom flat surface of about 1.0 to about 1.5 cm (about 0.4 to about 0.6 inches) extending inward from a vertical inner sidewall of the lip 227. In some embodiments, a sloped wall connection the bottom flat surface of the recessed portion 226 to the upper flat portion 225 is angle upward at about 25 to about 35 degrees, or about 30 degrees. In some embodiments, the ledge of the collar portion 224 is disposed about 0.38 to about 0.51 cm (about 0.15 to about 0.20 inches) below the upper surface of the upper flat portion 225. In some embodiments, the lower surface of the collar portion 224 is disposed about 0.61 to about 0.69 cm (about 0.24 to about 0.27 inches) below the ledge of the collar portion 224. In some embodiments, the outermost flat portion 306 of the collar portion 224 has a length of about 1.0 to about 1.3 cm (about 0.4 to about 0.5 inches). In some embodiments, the intermediate flat portion 304 of the collar portion 224 has a length of about 0.38 to about 0.8 cm (about 0.15 to about 0.3 inches). In some embodiments, the innermost flat portion 302 of the collar portion 224 has a length of about 1.3 to about 1.5 cm (about 0.5 to about 0.6 inches).

Upper surfaces of the outer deposition ring 142 can be texturized, for example with an aluminum arc spray, such as a twin wire arc spray to enhance particle retention. In some embodiments, the outer deposition ring 142 is texturized only between the upper surface of the lip 227 and the recessed portion 226 up to, but excluding, the upper flat portion 225.

As illustrated in Figure 2, the leg portion 220 of the inner deposition ring 140 extends into the recessed portion 226 of the outer deposition ring 142 to form a tortuous path 250 between the inner and outer deposition rings 140, 142. In some embodiments, the leg portion 220 of the inner deposition ring 140 is vertically spaced apart from the recessed portion 226 of the outer deposition ring 142 by a first gap 202 to ensure the rotating inner deposition ring 140 does not contact the stationary outer deposition ring 142 while also ensuring that sputtered material does not escape into an area beneath the substrate support 110. In some embodiments, the first gap 202 is about 0.114 cm to about 0.140 cm (about 0.045 inches to about 0.055 inches). The lip 223 is vertically spaced apart from the substrate 108 by a second gap 204 to ensure the inner deposition ring 140 does not contact and contaminate the substrate 108. In some embodiments, the second gap 204 is about 0.020 cm to about 0.030 cm (about 0.008 inches to about 0.012 inches). In some embodiments, the inner deposition ring 140 has a first inner diameter of about 29.2 cm (about 11.5 inches) and a first outer diameter of about 32.5 cm (about 12.8 inches). In some embodiments, the outer deposition ring 142 has a second inner diameter of about 31.0 cm (about 12.2 inches) and a second outer diameter between about 34.8 cm to about 37.1 cm (about 13.7 inches and about 14.6 inches).

In some embodiments, the outer deposition ring 142 includes a plurality of features 208 that rest on a component 210 of the substrate support when the outer deposition ring 142 is installed in the process chamber 100. Figure 3 is a perspective bottom view of the deposition ring 142 illustrating more clearly the plurality of features 208. As illustrated in Figure 3, the plurality of features 208 protrude from the intermediate flat portion 304 of the lower surface of the outer deposition ring 142. In some embodiments, the plurality of features 208 are equidistantly spaced from each other. In some embodiments, three features 208 are provided. In some embodiments, three features 208 are provided and are spaced 120 degrees apart from each other.

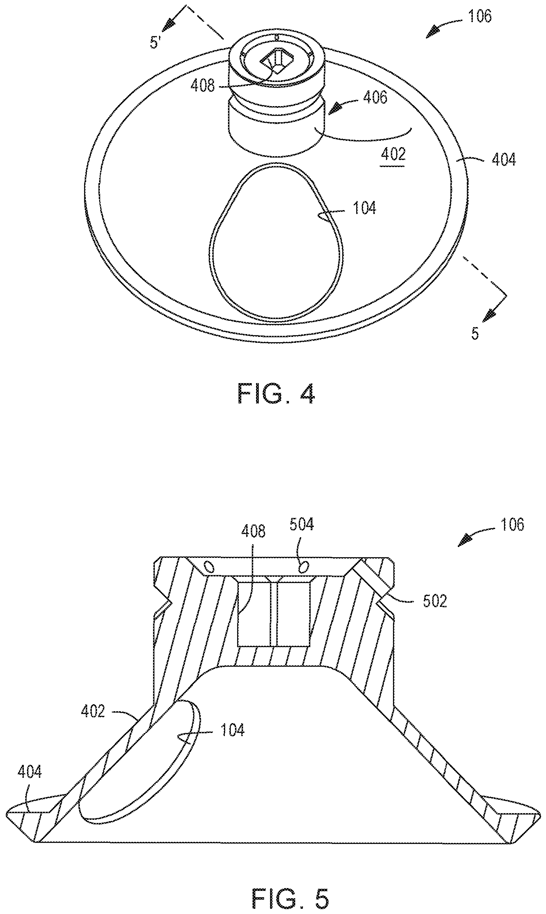

The following description of the rotatable shield 106 will be made with referenced to Figures 4 and 5. Figure 4 depicts a perspective top view of the rotatable shield 106 in accordance with some embodiments of the present disclosure. Figure 5 depicts a cross-sectional view of the rotatable shield 106 of Figure 4 taken along line 5-5'. In some embodiments, the rotatable shield includes a base 406, a conical portion 402 extending downward and radially outward from the base 406, and a collar portion 404 extending radially outward from the bottom of the conical portion 402. The hole 104 is formed in the conical portion 402. A mating hole 408 is formed in the upper surface of the base 406 to receive the shaft 132 to facilitate the rotation of the rotatable shield 106. The mating hole 408 has a shape corresponding to the shaft 132 and is configured to impart rotation from the shaft 132 to the rotatable shield 106, while eliminating the possibility of the shaft 132 rotating relative to the rotatable shield 106. That is, the mating hole 408 is shaped to prevent the shaft 132 from slipping within the mating hole 408 and rotating relative to the rotatable shield 106.

As illustrated in Figure 5, the base includes a plurality of holes 504 through which fixation elements extend to fix the rotatable shield 106 to the shaft 132. In some embodiments, the base 406 may further include a v-shaped channel 502 to provider an easily manufactured, secure mounting face for the fixation elements. In some embodiments, the hole 104 is egg-shaped to correspond to a shape of the shroud 126. In some embodiments, the hole 104 is defined by a first circle and second circle offset from each other along a line along the conical portion that intersects the central axis of the rotatable shield 106. The first circle is disposed closer to the outer edge of the rotatable shield 106 and has a larger diameter than the second circle. The hole if further defined by two tangent lines coupling the first and second circles to provide a smooth, continuous outline of the hole 104, for example, as shown in Figure 4. In some embodiments, the first circle has a diameter of about 10 to about 10.4 cm (about 4 to about 4.1 inches), the second circle has a diameter of about 7.6 to about 7.9 cm (about 3 to about 3.1 inches), and the first and second circles are offset by about 5.8 to about 6.1 cm (about 2.3 to about 2.4 inches).

In some embodiments, the rotatable shield 106 can have an overall height of about 28 to about 28.58 cm (about 11 to about 11.25 inches). In some embodiments, the rotatable shield 106 can have a maximum inner diameter (e.g., at the bottom end of the conical portion) of about 53 to about 53.98 cm (about 21 to about 21.25 inches). In some embodiments, the rotatable shield 106 can have a maximum outer diameter (e.g., at the end of the flange of the conical portion) of about 62.87 to about 64 cm (about 24.75 to about 25 inches). In some embodiments, the base 406 of the rotatable shield 106 can have an outer diameter of about 15.88 to about 16.5 cm (about 6.25 to about 6.5 inches). In some embodiments, the conical portion may be disposed at an angle of about 30 to about 50 degrees, or about 35 to about 45 degrees, or about 40 degrees. In some embodiments, the conical portion may have a thickness of about 0.64 to about 1.3 cm (about 0.25 to about 0.5 inches), or about 0.8 cm (about 0.3 inches). Interior surfaces of the rotatable shield 106 can be texturized, for example with an aluminum arc spray, such as a twin wire arc spray to enhance particle retention. In some embodiments, all surfaces of the rotatable shield 106 can be texturized as described above with the exception of the v-shaped channel 502 and all surfaces above the v-shaped channel 502.

While the foregoing is directed to embodiments of the present disclosure, other and further embodiments of the disclosure may be devised without departing from the basic scope thereof. The invention is defined by the claims.

## Claims

1. A process kit for use in a multi-cathode processing chamber (100), comprising:
a rotatable shield (106) having a base (406), a conical portion (402) extending downward and radially outward from the base (406), and a collar portion (404) extending radially outward from a bottom of the conical portion (402), wherein an egg-shaped hole (104) is formed through the conical portion (402);
an inner deposition ring (140) having a leg portion (202), a flat portion (221) extending radially inward from the leg portion (202), a first recessed portion (222) extending radially inward from the flat portion (221), and a first lip (223) extending upward from an innermost section of the first recessed portion (222), the inner deposition ring (140) being configured for being disposed atop a substrate support (110) of the multi-cathode processing chamber (100); and
an outer deposition ring (142) having a collar portion (224), an upper flat portion (225) disposed above and extending radially inward from the collar portion (224), a second recessed portion (226) extending inward from the upper flat portion (225), and a second lip (227) extending upward from an innermost section of the second recessed portion (226), wherein the leg portion (202) of the inner deposition ring (140) extends into the second recessed portion (226) of the outer deposition ring (142) to form a tortuous path (250) between the inner and outer deposition rings (140,142).

2. The process kit of claim 1, wherein at least one of:
a first inner diameter of the inner deposition ring (140) is about 29.2 cm (11.5 inches); or
a first outer diameter of the inner deposition ring (140) is about 32.5 cm (12.8 inches).

3. The process kit of claim 1, wherein at least one of:
a second inner diameter of the outer deposition ring (142) is about 31.0 cm (12.2 inches); or
a second outer diameter of the outer deposition ring (142) is between about 34.8 cm (13.7 inches) and 37.1 cm (14.6 inches).

4. The process kit of any of claims 1 to 3, further comprising:
a plurality of shrouds (126) configured to be disposed about a corresponding plurality of targets (114) between the plurality of targets (114) and the rotatable shield (106).

5. The process kit of any of claims 1 to 3, further comprising:
a conical shield (118), wherein a top section of the conical shield (118) is configured to surround a lower portion of the rotatable shield (106), and wherein a bottom section of the conical shield (118) is configured to surround a substrate support (110).

6. The process kit of claim 5, further comprising:
a cover ring (120) configured to rest on the bottom section of the conical shield (118).

7. A multi-cathode processing chamber (100), comprising:
a substrate support (110) to support a substrate (108);
a plurality of cathodes (102) coupled to a carrier and having a corresponding plurality of targets (114) to be sputtered onto the substrate (108); and
a process kit disposed within the multi-cathode processing chamber (100), the process kit as described in any of the preceding claims;
wherein the rotatable shield (106) is rotatably disposed between the substrate support (110) and the plurality of targets (114), and wherein the egg-shaped hole (104) exposes one of the plurality of targets (114) while covering a remainder of the plurality of targets (114);
wherein the inner deposition ring (140) is disposed atop the substrate support (110).

8. The multi-cathode processing chamber (100) of claim 7, wherein the leg portion (202) of the inner deposition ring (140) is vertically spaced apart from the second recessed portion (226) of the outer deposition ring (142) by a first gap (202) between about 0.114 cm (0.045 inches) and about 0.140 cm (0.055 inches), and wherein the first lip (223) of the inner deposition ring (140) is vertically spaced apart from the substrate (108) by a second gap between about 0.020 cm (0.008 inches) and about 0.030 cm (0.012 inches).

9. The multi-cathode processing chamber (100) of claim 7, wherein the plurality of cathodes (102) includes five cathodes, and further comprising a plurality of shrouds (126), each disposed between a corresponding one of the plurality of targets (114) and the rotatable shield (106).

## Patentansprüche

1. Prozesssatz zur Verwendung in einer Mehrkathoden-Verarbeitungskammer (100), umfassend:
eine drehbare Abschirmung (106), die eine Basis (406), einen konischen Abschnitt (402), der sich von der Basis (406) nach unten und radial nach außen erstreckt, und einen Kragenabschnitt (404) aufweist, der sich von einem Boden des konischen Abschnitts (402) radial nach außen erstreckt, wobei ein eiförmiges Loch (104) durch den konischen Abschnitt (402) gebildet ist;
einen inneren Abscheidungsring (140), der einen Schenkelabschnitt (202), einen flachen Abschnitt (221), der sich von dem Schenkelabschnitt (202) radial nach innen erstreckt, einen ersten vertieften Abschnitt (222), der sich von dem flachen Abschnitt (221) radial nach innen erstreckt, und eine erste Lippe (223) aufweist, die sich von einem innersten Bereich des ersten vertieften Abschnitts (222) nach oben erstreckt, wobei der innere Abscheidungsring (140) konfiguriert ist, um oben auf einem Substratträger (110) der Mehrkathoden-Verarbeitungskammer (100) angeordnet zu sein; und
einen äußeren Abscheidungsring (142), der einen Kragenabschnitt (224), einen oberen flachen Abschnitt (225), der oberhalb des Kragenabschnitts (224) angeordnet ist und sich von diesem radial nach innen erstreckt, einen zweiten vertieften Abschnitt (226), der sich von dem oberen flachen Abschnitt (225) nach innen erstreckt, und eine zweite Lippe (227) aufweist, die sich von einem innersten Bereich des zweiten vertieften Abschnitts (226) nach oben erstreckt, wobei sich der Schenkelabschnitt (202) des inneren Abscheidungsrings (140) in den zweiten vertieften Abschnitt (226) des äußeren Abscheidungsrings (142) erstreckt, sodass ein gewundener Pfad (250) zwischen dem inneren und dem äußeren Abscheidungsring (140, 142) gebildet wird.

2. Prozesssatz nach Anspruch 1, wobei mindestens eines gilt von:
ein erster Innendurchmesser des inneren Abscheidungsrings (140) beträgt etwa 29,2 cm (11,5 Zoll); oder
ein erster Außendurchmesser des inneren Abscheidungsrings (140) beträgt etwa 32,5 cm (12,8 Zoll).

3. Prozesssatz nach Anspruch 1, wobei mindestens eines gilt von:
ein zweiter Innendurchmesser des äußeren Abscheidungsrings (142) beträgt etwa 31,0 cm (12,2 Zoll); oder
ein zweiter Außendurchmesser des äußeren Abscheidungsrings (142) beträgt zwischen etwa 34,8 cm (13,7 Zoll) und 37,1 cm (14,6 Zoll).

4. Prozesssatz nach einem der Ansprüche 1 bis 3, ferner umfassend:
eine Vielzahl von Abdeckungen (126), die so konfiguriert sind, dass sie um eine entsprechende Vielzahl von Targets (114) zwischen der Vielzahl von Targets (114) und der drehbaren Abschirmung (106) angeordnet sind.

5. Prozesssatz nach einem der Ansprüche 1 bis 3, ferner umfassend:
eine konische Abschirmung (118), wobei ein oberer Bereich der konischen Abschirmung (118) konfiguriert ist, um einen unteren Abschnitt der drehbaren Abschirmung (106) zu umgeben, und wobei ein Bodenbereich der konischen Abschirmung (118) konfiguriert ist, um einen Substratträger (110) zu umgeben.

6. Prozesssatz nach Anspruch 5, ferner umfassend:
einen Deckring (120), der konfiguriert ist, um auf dem Bodenbereich der konischen Abschirmung (118) zu liegen.

7. Mehrkathoden-Verarbeitungskammer (100), umfassend:
einen Substratträger (110) zum Tragen eines Substrats (108);
eine Vielzahl von Kathoden (102), die mit einem Träger gekoppelt sind und eine entsprechende Vielzahl von Targets (114) aufweisen, die auf das Substrat (108) gesputtert werden sollen; und
einen Prozesssatz, der innerhalb der Mehrkathoden-Verarbeitungskammer (100) angeordnet ist, wobei der Prozesssatz wie in einem der vorstehenden Ansprüche beschrieben ist;
wobei die drehbare Abschirmung (106) drehbar zwischen dem Substratträger (110) und der Vielzahl von Targets (114) angeordnet ist, und wobei das eiförmige Loch (104) eines der Vielzahl von Targets (114) freilegt, während ein Rest der Vielzahl von Targets (114) abgedeckt wird;
wobei der innere Abscheidungsring (140) oben auf dem Substratträger (110) angeordnet ist.

8. Mehrkathoden-Verarbeitungskammer (100) nach Anspruch 7, wobei der Schenkelabschnitt (202) des inneren Abscheidungsrings (140) von dem zweiten vertieften Abschnitt (226) des äußeren Abscheidungsrings (142) um einen ersten Spalt (202) zwischen etwa 0,114 cm (0,045 Zoll) und etwa 0,140 cm (0,055 Zoll) vertikal beabstandet ist, und wobei die erste Lippe (223) des inneren Abscheidungsrings (140) von dem Substrat (108) um einen zweiten Spalt zwischen etwa 0,020 cm (0,008 Zoll) und etwa 0,030 cm (0,012 Zoll) vertikal beabstandet ist.

9. Mehrkathoden-Verarbeitungskammer (100) nach Anspruch 7, wobei die Vielzahl von Kathoden (102) fünf Kathoden aufweist, und ferner umfassend eine Vielzahl von Abdeckungen (126), die jeweils zwischen einem entsprechenden der Vielzahl von Targets (114) und der drehbaren Abschirmung (106) angeordnet sind.

## Revendications

1. Kit de traitement destiné à être utilisé dans une chambre de traitement multi-cathode (100), comprenant :
un écran rotatif (106) ayant une base (406), une partie conique (402) s'étendant vers le bas et radialement vers l'extérieur à partir de la base (406), et une partie collier (404) s'étendant radialement vers l'extérieur à partir d'un fond de la partie conique (402), dans lequel un trou en forme d'œuf (104) est formé à travers la partie conique (402) ;
un anneau de dépôt interne (140) ayant une partie jambe (202), une partie plate (221) s'étendant radialement vers l'intérieur à partir de la partie jambe (202), une première partie évidée (222) s'étendant radialement vers l'intérieur à partir de la partie plate (221), et une première lèvre (223) s'étendant vers le haut à partir d'une section la plus interne de la première partie évidée (222), l'anneau de dépôt interne (140) étant configuré pour être disposé au sommet d'un support de substrat (110) de la chambre de traitement multi-cathode (100) ; et
un anneau de dépôt externe (142) ayant une partie collier (224), une partie plate supérieure (225) disposée au-dessus de la partie collier (224) et s'étendant radialement vers l'intérieur à partir de celle-ci, une deuxième partie évidée (226) s'étendant vers l'intérieur à partir de la partie plate supérieure (225), et une deuxième lèvre (227) s'étendant vers le haut à partir d'une section la plus interne de la deuxième partie évidée (226), dans lequel la partie jambe (202) de l'anneau de dépôt interne (140) s'étend dans la deuxième partie évidée (226) de l'anneau de dépôt externe (142) pour former un chemin tortueux (250) entre les anneaux de dépôt interne et externe (140, 142).

2. Kit de traitement selon la revendication 1, dans lequel au moins l'un parmi :
un premier diamètre interne de l'anneau de dépôt interne (140) est d'environ 29,2 cm (11,5 pouces) ; ou
un premier diamètre externe de l'anneau de dépôt interne (140) est d'environ 32,5 cm (12,8 pouces).

3. Kit de traitement selon la revendication 1, dans lequel au moins l'un parmi :
un deuxième diamètre interne de l'anneau de dépôt externe (142) est d'environ 31,0 cm (12,2 pouces) ; ou
un deuxième diamètre externe de l'anneau de dépôt externe (142) est entre environ 34,8 cm (13,7 pouces) et 37,1 cm (14,6 pouces).

4. Kit de traitement selon l'une des revendications 1 à 3, comprenant en outre :
une pluralité de carénages (126) configurés pour être disposés autour d'une pluralité de cibles (114) correspondante entre la pluralité de cibles (114) et l'écran rotatif (106).

5. Kit de traitement selon l'une des revendications 1 à 3, comprenant en outre :
un écran conique (118), dans lequel une section du haut de l'écran conique (118) est configurée pour entourer une partie inférieure de l'écran rotatif (106), et dans lequel une section de fond de l'écran conique (118) est configurée pour entourer un support de substrat (110).

6. Kit de traitement selon la revendication 5, comprenant en outre :
un anneau de couverture (120) configuré pour reposer sur la section de fond de l'écran conique (118).

7. Chambre de traitement multi-cathode (100), comprenant :
un support de substrat (110) pour supporter un substrat (108) ;
une pluralité de cathodes (102) couplées à un porteur et ayant une pluralité de cibles (114) correspondante à pulvériser sur le substrat (108) ; et
un kit de traitement disposé à l'intérieur de la chambre de traitement multi-cathode (100), le kit de traitement étant tel que décrit dans l'une des revendications précédentes ;
dans laquelle l'écran rotatif (106) est disposé de manière rotative entre le support de substrat (110) et la pluralité de cibles (114), et dans laquelle le trou en forme d'œuf (104) expose l'une de la pluralité de cibles (114) tout en couvrant le reste de la pluralité de cibles (114) ;
dans laquelle l'anneau de dépôt interne (140) est disposé au sommet du support de substrat (110).

8. Chambre de traitement multi-cathode (100) selon la revendication 7, dans laquelle la partie jambe (202) de l'anneau de dépôt interne (140) est verticalement espacée de la deuxième partie évidée (226) de l'anneau de dépôt externe (142) par un premier espace (202) entre environ 0,114 cm (0,045 pouce) et environ 0,140 cm (0,055 pouce), et dans laquelle la première lèvre (223) de l'anneau de dépôt interne (140) est verticalement espacée du substrat (108) par un deuxième espace entre environ 0,020 cm (0,008 pouce) et environ 0,030 cm (0,012 pouce).

9. Chambre de traitement multi-cathode (100) selon la revendication 7, dans laquelle la pluralité de cathodes (102) comporte cinq cathodes, et comprenant en outre une pluralité de carénages (126), disposés chacun entre l'une correspondante de la pluralité de cibles (114) et l'écran rotatif (106).
